(19) Europäisches Patentamt / European Patent Office / Office européen des brevets

(11) **EP 2 299 507 A2**

(12) **EUROPEAN PATENT APPLICATION**

(43) Date of publication:
**23.03.2011 Bulletin 2011/12**

(51) Int Cl.:
***H01L 51/42*** *(2006.01)*

(21) Application number: **10011336.4**

(22) Date of filing: **17.08.2006**

(84) Designated Contracting States:
**DE ES FR GB**

(30) Priority: **22.08.2005 US 207791**

(62) Document number(s) of the earlier application(s) in accordance with Art. 76 EPC:
**06801856.3 / 1 929 557**

(71) Applicant: **The Trustees of Princeton University**
**Princeton, NJ 08544-0636 (US)**

(72) Inventor: **Forrest, Stepen R.**
**Ann Arbor**
**Michigan 48109 (US)**

(74) Representative: **Kiriczi, Sven Bernhard**
**Schneiders & Behrendt**
**Mühlthaler Strasse 91d**
**81475 München (DE)**

Remarks:
This application was filed on 29-09-2010 as a divisional application to the application mentioned under INID code 62.

(54) **Increased open-circuit-voltage organic photosensitive devices**

(57) The invention relates to a photosensitive device comprising: an anode and a cathode; and a first organic material and a second organic material forming a donor-acceptor heterojunction electrically connected between the anode and the cathode, wherein the first and second organic materials, as arranged in the photosensitive device, each have a Franck-Condon Shift of less than 0.5 eV.

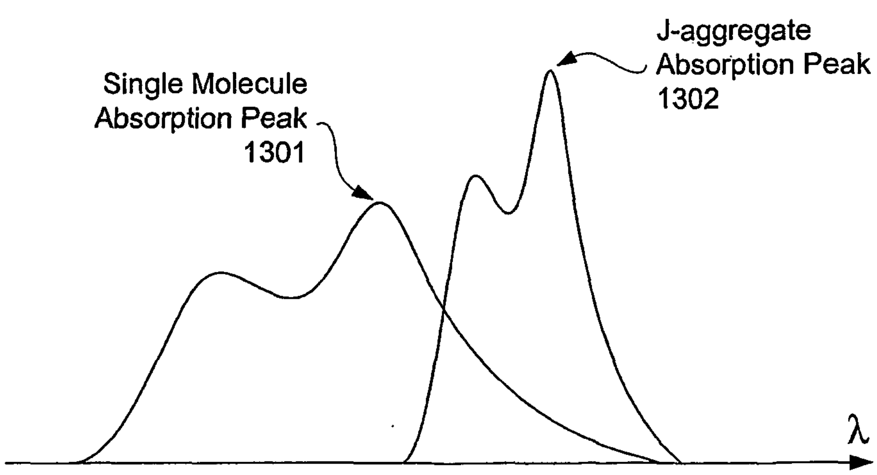


Figure 13

EP 2 299 507 A2

## Description

### United States Government Rights

This invention was made with U.S. Government support under Contract No. 339-6002 awarded by the U.S. Air Force Office of Scientific Research and under Contract No. 341-4141 awarded by U.S. Department of Energy, National Renewable Energy Laboratory. The government has certain rights in this invention.

### Joint Research Agreement

. The claimed invention was made by, on behalf of, and/or in connection with one or more of the following parties to a joint university-corporation research agreement: Princeton University, The University of Southern California, and Global Photonic Energy Corporation. The agreement was in effect on and before the date the claimed invention was made, and the claimed invention was made as a result of activities undertaken within the scope of the agreement.

### Field of the Invention

The present invention generally relates to organic photosensitive optoelectronic devices. More specifically, it is directed to organic photosensitive optoelectronic devices having organic donor-acceptor heterojunctions formed from materials and material arrangements selected to reduce the Franck-Condon shift after charge-carrier excitation.

### Background

Optoelectronic devices rely on the optical and electronic properties of materials to either produce or detect electromagnetic radiation electronically or to generate electricity from ambient electromagnetic radiation.

Photosensitive optoelectronic devices convert electromagnetic radiation into an electrical signal or electricity. Solar cells, also called photovoltaic ("PV") devices, are a type of Photosensitve optoelectronic device that is specifically used to generate electrical power. Photoconductor cells are a type of photosensitive optoelectronic device that are used in conjunction with signal detection circuitry which monitors the resistance of the device to detect changes due to absorbed light. Photodetectors, which may receive an applied bias voltage, are a type of photosensitive optoelectronic device that are used in conjunction with current detecting circuits which measures the current generated when the photodetector is exposed to electromagnetic radiation.

These three classes of photosensitive optoelectronic devices may be distinguished according to whether a rectifying junction as defined below is present and also according to whether the device is operated with an external applied voltage, also known as a bias or bias voltage. A photoconductor cell does not have a rectifying junction and is normally operated with a bias. A PV device has at least one rectifying junction and is operated with no bias. A photodetector has at least one rectifying junction and is usually but not always operated with a bias.

As used herein, the term "rectifying" denotes, *inter alia,* that an interface has an asymmetric conduction characteristic, *i.e.,* the interface supports electronic charge transport preferably in one direction. The term "semiconductor" denotes materials which can conduct electricity when charge carriers are induced by thermal or electromagnetic excitation. The term "photoconductive" generally relates to the process in which electromagnetic radiant energy is absorbed and thereby converted to excitation energy of electric charge carriers so that the carriers can conduct (i.e., transport) electric charge in a material. The term "photoconductive material" refers to semiconductor materials which are utilized for their property of absorbing electromagnetic radiation to generate electric charge carriers. As used herein, "top" means furthest away from the substrate, while "bottom" means closest to the substrate. There may be intervening layers, unless it is specified that the first layer is "in physical contact with" the second layer.

When electromagnetic radiation of an appropriate energy is incident upon an organic semiconductor material, a photon can be absorbed to produce an excited molecular state. In organic photoconductive materials, the generated molecular state is generally believed to be an "exciton," i.e., an electron-hole pair in a bound state which is transported as a quasi-particle. An exciton can have an appreciable life-time before geminate recombination ("quenching"), which refers to the original electron and hole recombining with each other (as opposed to recombination with holes or electrons from other pairs). To produce a.photocurrent, the electron-hole forming the exciton are typically separated at a rectifying junction.

In the case of photosensitive devices, the rectifying junction is referred to as a photovoltaic heterojunction. Types of organic photovoltaic heterojunctions include a donor-acceptor heterojunction formed at an interface of a donor material and an acceptor material, and a Schottky-barrier heterojunction formed at the interface of a photoconductive material and a metal.

FIG. 1 is an energy-level diagram illustrating an example donor-acceptor heterojunction. In the context of

organic materials, the terms "donor" and "acceptor" refer to the relative positions of the Highest Occupied Molecular Orbital ("HOMO") and Lowest Unoccupied Molecular Orbital ("LUMO") energy levels of two contacting but different organic materials. If the LUMO energy level of one material in contact with another is lower, then that material is an acceptor. Otherwise it is a donor. It is energetically favorable, in the absence of an external bias, for electrons at a donor-acceptor junction to move into the acceptor material.

As used herein, a first HOMO or LUMO energy level is "greater than" or "higher than" a second HOMO or LUMO energy level if the first energy level is closer to the vacuum energy level 10. A higher HOMO energy level corresponds to an ionization potential ("IP") having a smaller absolute energy relative to a vacuum level. Similarly, a higher LUMO energy level corresponds to an electron affinity ("EA") having a smaller absolute energy relative to vacuum level. On a conventional energy level diagram, with the vacuum level at the top, the LUMO energy level of a material is higher than the HOMO energy level of the same material.

After absorption of a photon 6 in the donor 152 or the acceptor 154 creates an exciton 8, the exciton 8 disassociates at the rectifying interface. The donor 152 transports the hole (open circle) and the acceptor 154 transports the electron (dark circle).

A significant property in organic semiconductors is carrier mobility. Mobility measures the ease with which a charge carrier can move through a conducting material in response to an electric field. In the context of organic photosensitive devices, a material that conducts preferentially by electrons due to a high electron mobility may be referred to as an electron transport material. A material that conducts preferentially by holes due to a high hole mobility may be referred to as a hole transport material. A layer that conducts preferentially by electrons, due to mobility and/or position the device; may be referred to as an electron transport layer ("ETL"). A layer that conducts preferentially by holes, due to mobility and / or position in the device, may be referred to as a hole transport layer ("HTL"). Preferably, but not necessarily, an acceptor material is an electron transport material and a donor material is a hole transport material.

How to pair two organic photoconductive materials to serve as a donor and an acceptor in a photovoltaic heterojunction based upon carrier mobilities and relative HOMO and LUMO levels is well known in the art, and is not addressed here.

As used herein, the term "organic" includes polymeric materials as well as small molecule organic materials that may be used to fabricate organic opto-electronic devices. "Small molecule" refers to any organic material that is not a polymer, and "small molecules" may actually be quite large. Small molecules may include repeat units in some circumstances. For example, using a long chain alkyl group as a substituent does not remove a molecule from the "small molecule" class. Small molecules may also be incorporated into polymers, for example as a pendent group on a polymer backbone or as a part of the backbone. Small molecules may also serve as the core moiety of a dendrimer, which consists of a series of chemical shells built on the core moiety. The core moiety of a dendrimer may be a fluorescent or phosphorescent small molecule emitter. A dendrimer may be a "small molecule." In general, a small molecule has a defined chemical formula with a molecular weight that is the same from molecule to molecule, whereas a polymer has a defined chemical formula with a molecular weight that may vary from molecule to molecule. As used herein, "organic" includes metal complexes of hydrocarbyl and heteroatom-substituted hydrocarbyl ligands.

For additional background explanation and description of the state of the art for organic photosensitive devices, including their general construction, characteristics, materials, and features, U.S. Patent No. 6,657,378 to Forrest et al. , U.S. Patent No. 6,580,027 to Forrest et al., and U.S. Patent No. 6,352,777 to Bulovic et al. are incorporated herein by reference.

Summary of Invention

The present invention is in particular directed to devices and methods according to following numbered paragraphs:

1. A photosensitive device comprising:

   an anode and a cathode; and
   a first organic material and a second organic material forming a donor-acceptor heterojunction electrically connected between the anode and the cathode, wherein the first and second organic materials, as arranged in the photosensitive device, each have a Franck-Condon Shift of less than 0.5 eV.

2. The photosensitive device of paragraph 1, wherein both the first and second organic materials as arranged in the photosensitive device have Franck-Condon Shifts of less than 0.2 eV.

3. The photosensitive device of paragraph 2, wherein the Franck-Condon Shift of at least one of the first and second organic materials as arranged in the photosensitive device is less than 0.1 eV.

4. The photosensitive device of paragraph 3, wherein both the first and second organic materials as arranged in the photosensitive device have Franck-Condon Shifts of less than 0.1 eV.

5. The photosensitive device of paragraph 1, wherein the first organic material and the second organic material, if measured in solution form, each have a Franck-Condon Shift of less than 0.5 eV.

6. The photosensitive device of paragraph 5, wherein both the first organic material and the second organic material, if measured in solution form, have Franck-Condon Shifts of less than 0.2 eV.

7. The photosensitive device of paragraph 6, wherein both the first organic material and the second organic material, if measured in solution form, have Franck-Condon Shifts of less than 0.1 eV.

8. The photosensitive device of paragraph 1, wherein at least one of the first and second organic materials is arranged to form a J-aggregate in the photosensitive device.

9.The photosensitive device of paragraph 1, wherein at least one of the first and second organic materials is arranged in the photosensitive device as a stack of at least three molecules oriented so that planes of the molecules are parallel, the stack being absent of disruptions, stacking faults, and dislocations.

10. The photosensitive device of paragraph, wherein at least one of the first and second organic materials consists of molecules with no single-bonded pendant side groups.

11. The photosensitive device of paragraph 1, wherein at least one of the first and second organic materials consists of planar molecules having fused rings.

12. The photosensitive device of paragraph of,wherein the planar molecules having fused rings are selected from the group consisting of benzene, porphyrins, phthalocyanines, and polyacenes.

13. The photosensitive device according of paragraph 1, wherein the donor-acceptor heterojunction forms a first photovoltaic cell, the device further comprising:

a stack of photovoltaic cells, each cell comprising a donor-acceptor heterojunction, the first photovoltaic cell being within the stack; and

an electrically conductive material between two of the photovoltaic cells in the stack,

the electrically conductive material being arranged as:

a charge transfer layer having no electrical connections external to the stack,

a recombination zone having no electrical connections external to the stack, or

an electrode having an electrical connection external to the stack.

14. The photosensitive device of paragraph 1 wherein the donor-acceptor heterojunction is selected from the group consisting of a bulk heterojunction, a mixed heterojunction, a planar heterojunction, and a hybrid heterojunction.

15. A method comprising:

providing a first electrically conductive layer;
arranging a first organic material and a second organic material over the first electrically conductive layer to form a donor-acceptor heterojunction; and
forming a second electrically conductive layer over the first and second organic materials,

wherein each of the first and second organic materials have a Franck-Condon Shift of less than 0.5 eV, as arranged to form the donor-acceptor heterojunction, if measured after the second electrically conductive layer is formed.

16. The method of paragraph 13, wherein the Franck-Condon Shift of both the first and second organic materials

as arranged to form the donor-acceptor heterojunction has a Franck-Condon Shift of less than 0.2 eV, if measured-after the second electrically conductive layer is formed.

17. The method of paragraph 16, wherein the Franck-Condon Shift of at least one of the first and second organic materials as arranged to form the donor-acceptor heterojunction has a Franck-Condon.Shift of less than 0.1 eV, if measured after the second electrically conductive layer is formed.

18. The method of paragraph 17, wherein the Franck-Condon Shift of both the first and second organic materials as arranged to form the donor-acceptor heterojunction have a Franck-Condon Shifts of less than 0.1 eV, if measured after the second electrically conductive layer is formed.

19. The method of paragraph 15, wherein each of the first and second organic materials, if measured in solution form, have a Franck-Condon Shift of less than 0.5 eV.

20. The photosensitive device of paragraph 19, wherein both the first organic material and the second organic material, if measured in solution form, have Franck-Condon Shifts of less than 0.2 eV.

21. The photosensitive device of paragraph 20, wherein both the first organic material and the second organic material, if measured in solution form, have Franck-Condon Shifts of less than 0.1 eV.

22. The method of paragraph 15, further comprising organizing at least one of the first and second organic materials to form a j-aggregate.

23. The method of paragraph 15, further comprising organizing at least one of the first and second organic materials to form a stack of at least three molecules oriented so that planes of the molecules are parallel, the stack being absent of disruptions, stacking faults, and dislocations.

24. The method of paragraph 15, wherein at least one of the first and second organic materials consists of molecules with no single-bonded pendant side groups.

25. The method of paragraph 15, wherein at least one of the first and second organic materials consists of planar molecules having fused rings.

26. The method of paragraph 15, wherein arranging the first organic material and the second organic material to form the donor-acceptor heterojunction comprises arranging the first and second organic materials to form a bulk heterojunction, a mixed heterojunction, a planar heterojunction, or a hybrid heterojunction.

27. A photosensitive device comprising:

an anode and a cathode; and

a first organic material and a second organic material forming a donor-acceptor heterojunction electrically connected between the anode and the cathode, wherein the first organic material and the second organic material, if measured in solution form, each have a Franck-Condon Shift of less than 0.5 eV.

28. The photosensitive device of paragraph 27, wherein both the first organic material and the second organic material, if measured in solution form, have Franck-Condon Shifts of less than 0.2 eV.

29. The photosensitive device of paragraph 28, wherein both the first organic material and the second organic material, if measured in solution form, have Franck-Condon Shifts of less than

30. The photosensitive device of paragraph 27, wherein a shape of molecules of the first organic material in solution form is substantially the same as a shape of the molecules of the first organic material as arranged in the photosensitive device.

31. The photosensitive device of paragraph 30, wherein the first organic material is arranged in the photosensitive device to form a stack of at least three molecules oriented so that planes of the molecules.are parallel, the stack being absent of disruptions, stacking faults, and dislocations.

32. The photosensitive device of paragraph 30, wherein a shape of molecules of the second organic material in solution form is substantially the same as a shape of the molecules of the second organic material as arranged in the photosensitive device.

33. The photosensitive device of paragraph 27, wherein at least one of the first and second organic materials is arranged to form a J-aggregate in the photosensitive device.

34. The photosensitive device of paragraph 27, wherein at least one of the first and second organic materials consists of molecules with no single-bonded pendant side groups.

35. A method comprising:

providing a first electrically conductive layer;
arranging a first organic material and a second organic material over the first electrically conductive layer to form a donor-acceptor heterojunction; and
forming a second electrically conductive layer over the first and second organic materials,
wherein each of the first and second organic materials, if measured in solution form, have a Franck-Condon Shift of less than 0.5 eV.

36. The photosensitive device of paragraph 35, wherein both the first organic material and the second organic material, if measured in solution form, have Franck-Condon Shifts of less than 0.2 eV.

37. The photosensitive device of paragraph 36, wherein both the first organic material and the second organic material, if measured in solution form, have Franck-Condon Shifts of less than 0.1 eV.

38. The method of paragraph 35, further comprising organizing at least one of the first and second organic materials to form a j-aggregate.

39. The method of paragraph 35, furhter comprising organizing at least one of the first and second organic materials to form a stack of at least three molecules oriented so that planes of the molecules are parallel, the stack being absent of disruptions, stacking faults, and dislocations.

40. The method of paragraph 35, wherein at least one of the first and second organic materials consists of molecules with no single-bonded pendant side groups.

Investigation has revealed that one of the factors causing low power conversion efficiency ($\eta_p$) in organic photosensitive devices is the Franck-Condon Shift (FCS). The FCS is a non-radiative loss mechanism which occurs when charge carrier excitation induces a reorganization of the organic molecules employed as the donor and/or the acceptor. The power conversion efficiency (ηp) of photosensitive devices decreases as the Franck-Condon Shift experienced by the photoconductive materials increases.

A photosensitive device in accordance with embodiments of the present invention may include a first organic material and a second organic material forming a donor-acceptor heterojunction electrically connected between an anode and a cathode, where the first and second organic materials, as arranged in the photosensitive device, each have a Franck-Condon Shift of less than 0.5 eV. Preferably, one or both of the first and second organic material as arranged in the photosensitive device have Franck-Condon Shifts of less than 0.2 eV, and more preferably, of less than 0.1 eV.

Several materials or material arrangements may be used to achieve a low FCS. At least one of the first and second organic materials may be arranged in the device to form a J-aggregate, or as an orderly stack of at least three molecules. If arranged as an orderly stack, the molecules of the stack are oriented so that their planes are parallel, the orderly stack being absent of disruptions, stacking faults, and dislocations. At least one of the first and second organic materials may consist of stiff molecules such as molecules with no single-bonded pendant side groups or planar molecules having fused rings. Such planar molecules having fused rings may be selected, for example, from the group consisting of benzene, porphyrins, phthalocyanines, and polyacenes. "Planar" means the conjugated electron system of the molecule is approximately lying in a plane."

. The donor-acceptor heterojunction may form a first PV cell, arranged in a stack of a plurality of PV cells, each cell comprising a donor-acceptor heterojunction. Electrically conductive material(s) may be disposed between each of the cells, or the cells may be stacked without intervening zones/layers. The conductive materials(s) may be arranged as, for example, a charge transfer layer having no electrical connections external to the stack, a recombination zone

having no electrical connections external to the stack, or an intermediate electrode having an electrical connection external to the stack. If a stack contains multiple electrically conductive zones/layers, each region of conductive material may be arranged as a same type (e.g., charge transfer, recombination, electrode), or some conductive regions may differ in type from others.

The donor-accepted heterojunction of a cell may be arranged to form a bulk, mixed, planar, or hybrid heterojunction. If cells are arranged as a stack, each cell may contain a same type of heterojunction or some cells may differ in type from others.

A related method for forming the device may include providing a first electrically conductive layer, arranging a first organic material and a second organic material over the first electrically conductive layer to form a donor-acceptor heterojunction, and forming a second electrically conductive layer over the first and second organic materials. Each of the first and second organic materials has an FCS of less than 0.5 ev.as arranged to form the donor-acceptor heterojunction, if measured after the second electrically conductive layer is formed. Preferably, one or both of the first and second organic material as arranged to form the donor-acceptor junction has an FCS of less than 0.2 eV, and more preferably, of less than 0.1 eV, if measured after the second electrically conductive layer is formed.

The method may further comprise organizing at least one of the first and second organic materials to form a J-aggregate, and/or as an orderly stack of at least three molecules. If organized as an orderly stack, each molecule in the stack is arranged in a parallel-planar arrangement, the orderly stack being absent of disruptions, stacking faults, and dislocations. At least one of the first and second organic materials may consist of stiff molecules such as molecules with no single-bonded pendant side groups or of planar molecules having fused rings. Such planar molecules having fused rings may be selected, for example, from the group consisting of benzene, porphyrins, phthalocyanines, and polyacenes.

Arranging the first organic material and the second organic material to form the donor-acceptor heterojunction may include arranging the materials to form a bulk, mixed, planar, or hybrid heterojunction.

Embodiments of the present invention may also be based upon the Franck-Condon Shift of molecules measured in solution. A photosensitive device in accordance with embodiments of the present invention may include a first organic material and a second organic material forming a donor-acceptor heterojunction electrically connected between an anode, where the first organic material and the second organic material, if measured in solution form, each have a Franck-Condon Shift of less than 0.5 eV. Preferably, one or both of the first and second organic material have Franck-Condon Shifts of less than 0.2 eV, and more preferably, of less than 0.1 eV, if measured in solution form.

certain molecules and molecular arrangements tend to have a lower or equivalent FCS when arranged in a structure than they have in solution. To assure that an FCS in a device will be less than or equal to the FCS in solution form, materials and material arrangements are preferably used to form the heterojunction in which a shape of a molecule for the first and/or second organic material in solution is substantially the same as a shape of the molecules as arrange in the device. For example, the first and/or second organic materials arranged in a crystalline structure generally will have an FCS that is equal to or lower than the FCS for a same material in solution due to the ordered nature of the lattice, so long as there are not twists in the molecule (e.g., a twist in a pendant side group) in the structure in comparison to the orientation of the molecule in solution.

At least one of the first and second organic materials may be arranged to form a J-aggregate, or as an orderly stack of at least three molecules. If arranged as an orderly stack, the molecules in the stack are oriented so that planes of the molecules are parallel, the orderly stack being absent of disruptions, stacking faults, and dislocations. At least one of the first and second organic materials may consist of stiff molecules such as molecules with no single-bonded pendant side groups or planar molecules having fused rings. Such planar molecules having fused rings may be selected, for example, from the group consisting of benzene, porphyrins, phthalocyanines, and polyacenes.

A related method for forming the device may include providing a first electrically conductive layer, arranging a first organic material and a second organic material over the first electrically conductive layer to form a donor-acceptor heterojunction, and forming a second electrically conductive layer over the first and second organic materials. Each of the first and second organic materials has an FCS of less than 0.5 eV, if measured in solution form. Preferably, one or both of the first and second organic material has an FCS of less than 0.2 eV, and more preferably, of less than 0.1 eV, if measured in solution form.

The method may further comprise organizing at least one of the first and second organic materials to form a J-aggregate, and/or as an orderly stack of at least three molecules. If organized as an orderly stack, the molecules are oriented so that planes of the molecules are parallel, the orderly stack being absent of disruptions, stacking faults, and dislocations. At least one of the first and second organic materials may consist of stiff molecules such as molecules with no single-bonded pendant side groups or of planar molecules having fused rings. Such planar molecules having fused rings may be selected, for example, from the group consisting of benzene, porphyrins, phthalocyanines, and polyacenes.

In each of the devices and methods described above, the characteristics of the materials and material arrangements may be use separately or interchangeably to obtain low FCS. For example, molecules with no single-bonded pendant side groups or planar molecules having fused rings may be arranged in a J-aggregate or an orderly stack. As

another example, the planar molecules having fused rings may have no single-bonded pendant side groups. Moreover, FCS measurement in solution can be used to select materials, with the FCS of the device being confirmed by measuring the FCS of the same materials as arranged in a device.

## Brief Description of the Drawings

FIG. 1 is an energy level diagram illustrating a donor-acceptor heterojunction.

FIG. 2. illustrates an organic photosensitive device including a donor-acceptor heterojunction.

FIG. 3 illustrates a donor-acceptor bilayer forming a planar heterojunction.

FIG. 4 illustrates a hybrid heterojunction including a mixed heterojunction between a donor layer and an acceptor layer.

FIG. 5 illustrates a bulk heterojunction.

FIG. 6 illustrates an organic photosensitive device including a Schottky-barrier heterojunction.

FIG. 7 illustrates tandem photosensitive cells in series.

FIG. 8 illustrates tandem photosensitive cells in parallel.

FIG. 9 shows a non-radiative energy loss resulting from a Franck-Condon Shift.

FIG. 10 is an abstraction of a relaxed molecule and the molecule reorganized after charge carrier excitation.

FIG. 11 shows a difference in absorption and emission spectra characteristic of a example molecule that experiences a Franck-Condon Shift.

FIG .12A shows a random arrangement of molecules.

FIG. 12B shows the molecules of FIG. 12A arranged as a J-aggregate.

FIG. 13 shows the red-shift in absorption spectra that may occur when molecules are arranged as a J-aggregate.

The figures are not necessarily drawn to scale.

## Detailed Description

An organic photosensitive device comprises at least one photoactive region in which light is absorbed to form an exciton, which may subsequently dissociate into an electron and a hole. FIG. 2 shows an example of an organic photosensitive optoelectronic device 100 in which the photoactive region 150 comprises a donor-acceptor heterojunction. The "photoactive region" is a portion of a photosensitive device that absorbs electromagnetic radiation to generate excitons that may dissociate in order to generate an electrical current. Device 100 comprises an anode 120, an anode smoothing layer 122, a donor 152, an acceptor 154, an exciton blocking layer ("EBL") 156, and a cathode 170, over a substrate 110.

Examples of EBL 156 are described in U.S. Patent No. 6,451,415 to Forrest et al., which is incorporated herein by reference for its disclosure.related to EBLs. Additional background explanation of EBLs may also be found in Peumans et al., "Efficient photon harvesting at high optical intensities in ultrathin organic double-heterostructure photovoltaic diodes," Applied Physics Letters 76, 2650-52. (2000). EBLs reduce quenching by preventing excitons from migrating out of the donor and/or acceptor materials.

The terms "electrode" and "contact" are used interchangeably herein to refer to a layer that provides a medium for delivering photo-generated current to an external circuit or providing a bias current or voltage to the device. As illustrated in FIG. 2, anode 120 and cathode 170 are examples. Electrodes may be composed of metals or "metal substitutes." Herein the term "metal" is used to embrace both materials composed of an elementally pure metal, and also metal alloys which are materials composed of two or more elementally pure metals. The term "metal substitute" refers to a material that is not a metal within the normal definition, but which has the metal-like properties such as conductivity, such as doped wide-bandgap semiconductors, degenerate semiconductors, conducting oxides, and conductive polymers. Electrodes may comprise a single layer or multiple layers (a "compound" electrode), may be transparent, semi-transparent, or opaque. Examples of electrodes and electrode materials include those disclosed in U.S. Patent No. 6,352,777 to Bulovic *et a*l., and U.S. Patent No. 6,420,031, to Parthasarathy, *et"al.,* each incorporated herein by reference for disclosure of these respective features. As used herein, a layer is said to be "transparent" if it transmits at least 50% of the ambient electromagnetic radiation in a relevant wavelength.

The substrate 110 may be any suitable substrate that provides desired structural properties. The substrate may be flexible or rigid, planar or non-planar. The substrate may be transparent, translucent or opaque. Rigid plastics and glass are examples of preferred rigid substrate materials. Flexible plastics and metal foils are examples of preferred flexible substrate materials.

An anode-smoothing layer 122 may be situated between the anode layer 120 and the donor layer 152. Anode-smoothing layers are described in U.S. Patent 6,657,378 to Forrest et al., incorporated herein by reference for its disclosure related to this feature.

In FIG. 2, the photoactive region 150 comprises the donor material 152 and the acceptor material 154. Organic

materials for use in the photoactive region may include organometallic compounds, including cyclometallated organometallic compounds. The term "organometallic" as used herein is as generally understood by one of ordinary skill in the art and as given, for example, in Chapter 13 of "Inorganic Chemistry" (2nd Edition) by Gary L. Miessler and Donald A. Tarr, Prentice Hall (1999).

Organic layers may be fabricated using vacuum deposition, spin coating, organic vaporphase deposition, inkjet printing and other methods known in the art.

Examples of various types of donor-acceptor heterojunctions are shown in FIGS. 3-5. FIG. 3 illustrates a donor-acceptor bilayer forming a planar heterojunction. FIG. 4 illustrates a hybrid heterojunction including a mixed heterojunction 153 comprising a mixture of donor and acceptor materials. FIG. 5 illustrates an idealized "bulk" heterojunction. A bulk heterojunction, in the ideal photocurrent case, has a single continuous interface between the donor material 252 and the acceptor material 254, although multiple interfaces typically exist in actual devices. Mixed and bulk heterojunctions can have multiple donor-acceptor interfaces as a result of having plural domains of material. Domains that are surrounded by the opposite-type material (e.g., a domain of donor material surrounded by acceptor material) may be electrically isolated, such that these domains do not contribute to photocurrent. Other domains may be connected by percolation pathways (continuous photocurrent pathways), such that these other domains may contribute to photocurrent. The distinction between a mixed and a bulk heterojunction lies in degrees or phase separation between donor and acceptor materials. In a mixed heterojunction, there is very little or no phase separation (the domains are very small, *e.g.,* less than a few nanometers), whereas in a bulk heterojunction, there is significant phase separation (e.g., forming domains with sizes of a few nanometers to 100 nm).

Small-molecule mixed heterojunctions may be formed, for example, by co-deposition of the donor and acceptor materials using vacuum deposition or vapor deposition. Small-molecule bulk heterojunctions may be formed, for example, by controlled growth, co-deposition with post-deposition annealing, or solution processing. Polymer mixed or bulk heterojunctions may be formed, for example, by solution processing of polymer blends of donor and acceptor materials.

If a photoactive region includes a mixed layer (153) or bulk layers (252, 254) and one or both of the donor (152) and acceptor layers (154), the photoactive region is said to include a "hybrid" heterojunction. The arrangement of layers in FIG. 4 is an example. For additional explanation of hybrid heterojunctions, U.S. Application 10/910,371 entitled "High efficiency organic photovoltaic cells employing hybridized mixed-planar heterojunctions" by Jiangeng Xue *et al.,* filed August 4, 2004, is hereby incorporated by reference.

In general, planar heterojunctions have good carrier conduction, but poor exciton dissociation; a mixed layer has poor carrier conduction and good exciton dissociation, and a bulk heterojunction has good carrier conduction and good exciton dissociation, but may experience charge build-up at the end of the material "cul-de-sacs," lowering efficiency. Unless otherwise stated, planar, mixed, bulk, and hybrid heterojunctions may be used interchangeably as donor-acceptor heterojunctions throughout the embodiments disclosed herein.

FIG. 6. shows an example of a organic photosensitive optoelectronic device 300 in which the photoactive region 350 is part of a Schottky-barrier heterojunction. Device 300 comprises a transparent contact 320, a photoactive region 350 comprising an organic photoconductive material 358, and a Schottky contact 370. The Schottky contact 370 is typically formed as a metal layer. If the photoconductive layer 358 is an ETL, a high work function metal such as gold may be used, whereas if the photoconductive layer is an HTL, a low work function metal such as aluminum, magnesium, or indium may be used. In a Schottky-barrier cell, a built-in electric field associated with the Schottky barrier pulls the electron and hole in an exciton apart. Generally, this field-assisted exciton dissociation is not as efficient as the disassociation at a donor-acceptor interface.

The devices as illustrated are connected to an element 190. If the device is a photovoltaic device, element 190 is a resistive load which ,consumes or stores power. If the device is a photodetector, element 190 is a current detecting circuit which measures the current generated when the photodetector is exposed to light, and which may apply a bias to the device (as described for example in Published U.S. Patent Application 2005-0110007 A1, published May 26, 2005 to Forrest et al.*).* If the rectifying junction is eliminated from the device (e.g., using a single photoconductive material as the photoactive region), the resulting structures may be used as a photoconductor cell, in which case the element 190 is a signal detection circuit to monitor changes in resistance across the device due to the absorption of light. Unless otherwise stated, each of these arrangements and modifications may be used for the devices in each of the drawings and embodiments disclosed herein.

An organic photosensitive optoelectronic device may also comprise transparent charge transfer layers, electrodes, or charge recombination zones. A charge transfer layer may be organic or inorganic, and may or may not be photoconductively active. A charge transfer layer is similar to an electrode, but does not have an electrical connection external to the device and only delivers charge carriers from one subsection of an optoelectronic device to the adjacent subsection. A charge recombination zone is similar to a charge transfer layer, but allows for the recombination of electrons and holes between adjacent subsections of an optoelectronic device. A charge recombination zone may include semi-transparent metal or metal substitute recombination centers comprising nanoclusters, nanoparticles, and/or nanorods, as described for example in U.S. Patent No. 6,657,378 to Forrest et al.*;* U.S. Patent Application 10/915,410 entitled

"Organic Photosensitive Devices." by Rand *et al.,* filed August 11, 2004; and U.S. Patent Application 10/979,145 entitled "Stacked Organic Photosensitive Devices" by Forrest *et al.,* filed November 3, 2004; each incorporated herein by reference for its disclosure of recombination zone materials and structures. A charge recombination zone may or may not include a transparent matrix layer in which the recombination centers are embedded. A charge transfer layer, electrode, or charge recombination zone may serve as a cathode and/or an anode of subsections of the optoelectronic device. An electrode or charge transfer layer may serve as a Schottky contact.

FIGS. 7 and 8 illustrate examples of tandem devices including such transparent charge transfer layers, electrodes, and charge recombination zones. In device 400 in FIG. 7, photoactive regions 150 and 150 are stracked electrically in series with an intervening conductive region 460. As illustrated without external electrical connections, intervening conductive region 460 may be a charge recombination zone or may be a charge transfer layer. As a recombination zone, region 460 comprises recombination centers 461 with or without a transparent matrix layer. If there is no matrix layer, the arrangement of material forming the zone may not be continuous across the region 460. Device 500 in FIG. 8 illustrates photoactive regions 150 and 150' stacked electrically in parallel, with the top cell being in an inverted configuration (i.e., cathode-down). In each of FIGS. 7 and 8, the photoactive regions 150 and 150' and blocking layers 156 and 156' may be formed out of the same respective materials, or different materials, depending upon the application. Likewise, photoactive regions 150 and 150' may be a same type *(i.e.,* planar, mixed, bulk, hybrid) of heterojunction, or may be of different types.

In each of the devices described above, layers may be omitted, such as the exciton blocking layers. Other layers may be added, such as reflective layers or additional photoactive regions. The order of layers may be altered or inverted. A concentrator or trapping configuration may be employed to increase efficiency, as disclosed, for example in U.S. Patent No. 6,333,458 to Forrest et al. and U.S. Patent No. 6,440,769 to Peumans et al.*,* which are incorporated herein by reference. Coatings may be used to focus optical energy into desired regions of a device, as disclosed, for example in US Patent Application No. 10/857,747 entitled "Aperiodic dielectric multilayer stack" by Peumans *et al.,* filed June 1, 2004, which is incorporated herein by reference. In the tandem devices, transparent insulative layers may be formed between cells, with the electrical connection between the cells being provided via electrodes. Also in the tandem devices, one or more of the photoactive regions may be a Schottky-barrier heterojunction instead of a donor-acceptor heterojunction. Arrangements other than those specifically described may be used.

Currently, small molecule photovoltaic cells have a low open-circuit voltage (Voc) leading to a low power conversion efficiency (ηp). This is identified as due primarily to the large reorganization of a molecule in its excited state; giving rise to a large Franck-Condon Shift (FCS). Typically, 0.5 to 1.0V is lost from the absorption energy due to these effects, which if eliminated, could improve today's $Vo_c \approx 0.5V$ to $V_{oc} > 1.5V$, yielding a three-times improvement in ηp.

The reorganization of a molecule in the excited state- creating the Franck-Condon Shift (FCS) results in a non-radiative energy loss. For example, as illustrated in FIG. 9, after an electron is excited (901) from the HOMO level to the LUMO level at time $t_1$, charge carrier energy is lost (902) due to a change in the structure of the molecule at time $t_2$. Additionally, the HOMO level may move higher (903), resulting in a relative decrease in the energy difference between the excited electron and a corresponding hole. An example of this molecular reorganization illustrated in FIG. 10. At time $t_1$, the molecule (1001) is substantially planar, whereas at time $t_2$, the shape of the molecule (1001') has been distorted, absorbing energy and effectively lowering the LUMO. In general, less polar molecules experience less FCS, whereas more polar molecules experience more FCS.

The magnitude of the Franck-Condon Shift of a molecule can be determined by the difference in energy between the dominant absorption peak and the dominant emission peak of the acceptor/donor molecules across the infrared, visible, and ultraviolet wavelength range. FIG. 11 illustrates the absorption and emission wavelength spectra of example molecules, having a dominant absorption peak 1101 and a dominant emission peak 1102. These dominant peaks are sometimes referred to as a "characteristic absorption wavelength" and "characteristic emission wavelength," respectively, which corresponds to the maximum absorption and emission peaks.

The FCS is approximately the difference in energy between the respective peaks. The relationship between energy E (eV) and wavelength λ. (m) is:

$$E = \frac{hc}{q\lambda}$$

where *h* is the Planck constant ($6.626 \times 10^{-34}$ J-s), c is the velocity of light in a vacuum ($2.998 \times 10^{8}$ m/s), and q is electronic charge ($1.602 \times 10^{-19}$ J/eV). Additional background discussions regarding the nature and measurement of the Franck-Condon Shift can be found in Chapter 1 of "Electronic Process in Organic Crystals and Polymers," 2nd ed., by Martin Pope and Charles Swenberg, Oxford University Press (1999).

In accordance with embodiments of the present invention, the organic donor material *(e.g.,* of layers 152, 153,

252) and the organic acceptor material (e.g., of layers 154, 153, 254) forming a donor-acceptor heterojunction of the organic photosensitive optoelectronic devices 100, 400, 500 are selected so that the donor and the acceptor each have a Franck-Condon shift of less than 0.5 eV. Preferably, one or both of the materials are selected so that the donor and/or the acceptor have a FCS of less than 0.2 eV, and more preferably less than 0.1 eV.

Since the reorganizing of a molecule can directly affect the Franck-Condon shift experienced by the molecule, FCS measurements may be different for a molecule in a structure that confines reorganization and a free molecule. For example, an increased FCS may result when solvent in a solution holding an organic molecule is evaporated to form an amorphous solid and the molecule may twist, only to twist again when a charge is placed upon the molecule. Likewise, a molecule prone to twisting in solution may be constrained by surrounding molecules when placed in a solid.

Accordingly, two approaches can be taken to identifying which materials will have an FCS below 0.5 eV, 0.2 eV, or 0.1 eV. A first approach is to measure the FCS of the material as arranged in a stack of layers (e.g., determine the emission and absorption peaks of the material as arranged in a device, or measuring the FCS-induced voltage drop across a stack structure). A second approach is to measure the FCS of a material in solution form *(i.e.,* as a free molecule), and to consider how FCS may change from solution to solid. The first and second approaches may also be combined.

Data exists in the art for absorption and emission characteristics of many materials when arranged within a structure. For example, see "Study of localized and extended excitons in 3,4,9,10-perylenetetracarboxylic dianhydride (PTCDA) I. Spectroscopic properties of thin films and solution" by Bulovic et al., Chemical Physics 210, 1-12 (1996), which discloses absorption and fluorescence spectra of PTCDA in solution and in solid thin films.

For other materials, data for the materials measured as arranged in a structure may not be readily available in the literature, requiring additional testing to select materials. Methods for measuring emission (e.g., photoluminescence, electroluminescence, etc.) and absorption spectra are well known in the art. Although the absorption due to a particular layer in a multi-layer photoactive region may not be measured accurately, a test structure including a single layer of interest may be used to determine the material's absorption spectra as arranged in a layer.

Another option is to use the absorption and emission spectra of materials in solution to select material for a device. Absorption and emission data for molecules in solution is widely available. Such solution data may serve as a predictor of what the FCS will be in a structure.

For many materials and material structures, the FCS in a structure will be the same or lower than the FCS in solution, predictably resulting in a device having improved efficiency, while simplifying material selection and testing. To assure that a low FCS in solution will be less than or equal to the FCS in a device, materials and material arrangements are preferably used to form the heterojunction in which a shape of a molecule for the donor/acceptor in solution is substantially the same as a shape of the molecules as arranged in the device.

Several materials or material arrangements may be used to achieve a low FCS in a device. One example of a donor/acceptor material arrangement with a low FCS are J-aggregates. Aggregates are one, two, or three dimensional arrangements of ordered molecules. J-aggregates are a pure body of at least three molecules that are regularly arranged and loosely bonded, and which behave as a single molecule. J-aggregates have a same or lower FCS than the molecules forming the J-aggregate have in solution or in an amorphous solid. FIG. 12A illustrates a loose collection of molecules, whereas FIG. 12B illustrates the same molecules arranged as a J-aggregate. Compared with the absorption band of the loose collection of single molecules (1301, FIG. 13), the absorption band of molecules arranged as a J-aggregate (1302) is shifted toward a longer wavelength, and may be sharpened (spectral narrowing). J-aggregates may be arranged as slip stacks, where each stack is a single-dimensional arrangement of molecules. J-aggregates generally do not provide broad spectral coverage.

Any of several methods may be used to form a J-aggregrate. For example, several methods have been developed for inducing aggregate formation in aqueous solutions, such as raising the dye concentration in solution, using highly concentrated electrolytic solutions, and by adding certain polyelectrolyes. See, e.g., "Self Assembly of Cyanine Dye on Clay Nanoparticles" by Dixon et al., 3 American Journal of Undergraduate Research 29-34 (2005).

As demonstrated by the red-shift of the absorption spectra in FIG. 13, loosely arranged molecules (e.g., FIG. 12A) may have a larger FCS than if arranged to form a J-aggregate. A property of a J-aggregate for some molecules is a reduction of the FCS, such that a molecule having an FCS above the preferred thresholds of 0.5 eV, 0.2 eV, and 0.1 eV may nevertheless yield an FCS below the respective threshold when arranged as a J-aggregate. Accordingly, organic molecules otherwise appearing to be unsuitable for use as donors and acceptors due to a high FCS and thus poor power conversion efficiency may yield high efficiency devices when arranged to form J-aggregates.

Another example of a donor/acceptor material arrangement with a low FCS is an orderly stack of molecules. Stacks are a class of single-dimensional aggregate in which planar molecules are stacked so that their planes are parallel. An orderly stack is an arrangement of at least three molecules that is absent of disruptions, stacking faults, and dislocations. An example of how to deposit materials to form stacks is PTCDA as described in "Ultrathin Organic Films Grown By Organic Molecular Beam Deposition and Related Techniques" by Forrest, 97 Chemical Review 1793-1896 (1997). Arranging molecules into orderly stacks tends to reduce FCS, in comparison to the same molecules in solution

or an amorphous solid. As with J-aggregates, some molecules experience a red-shift of the absorption spectra when arranged in orderly stacks. Thus, while the molecules arranged to form an orderly stack may individually have an FCS above the preferred thresholds of > 0.5 eV, > 0.2 eV, and > 0.1 eV if measured outside of the stack, the molecules may nonetheless yield an FCS below the respective threshold when arranged as an orderly stack.

An example of donor/acceptor materials with a low FCS are stiff molecules that do not undergo substantial reorganization in the excited state. An advantage of stiff molecules is the availability of broader spectral coverage than is generally provided by aggregates, and the ability to form layers of mixed molecules. Additionally, stiff molecules tend to have similar FCS values in both solution and amorphous solids., and have equivalent or lower FCS values when arranged in an orderly stack or J-aggregate. One example of stiff molecules are molecules with no single-bonded pendant side groups. For example, the COOH on Fluorescein 27 and Rhodamine 110 (illustrated in Table 1) are materials with a single-bonded pendant side group, having a low FCS in solution, that might twist when arranged in some structures (e.g., in an amorphous layer), increasing the FCS, whereas pyrromethenes (e.g., Pyrromethene 546, 556, 567, 580, 597, and 650) do not have a single-bonded pendant side group and therefore are not expected to have an increased FCS compared to solution when arranged in a structure due to this twist mechanism. Another example of stiff molecules are planar molecules having fused rings, such as benzene, porphyrins, phthalocyanines, and polyacenes.

The characteristics of the materials and material arrangements described above may be use separately or interchangeably to obtain low FCS For example, stiff molecules may be arranged in a J-aggregate or orderly stack. As another example, the planar molecules having fused rings may have no single-bonded pendant side groups.

Specific example materials are presented below in Table 1, with the FCS in solution of each material being calculated from the emission and absorption peaks in Table 2:

Table 1

| Material | Constitution | Molecule |
|---|---|---|
| Fluorescein 27 | 9-(o-Carboxyphenyl)-2,7-dichloro-6-hydroxy-3H-xanthen-3-on 2,7-Dichlorofluorescein | 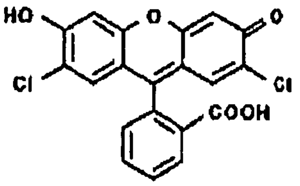 |
| Sulforhodamin e B | Ethanaminium, N-[(6-diethylamino)-9-(2,4-disulfophenyl)-3H-xanthen-3-ylidene]-N-ethylhydroxid, inner salt, sodium salt | 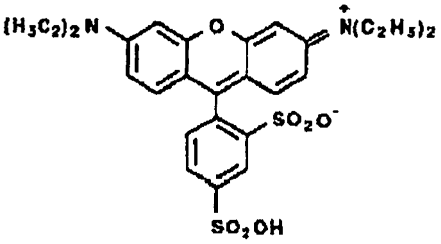 |
| Uranin | Disodium Fluorescein | 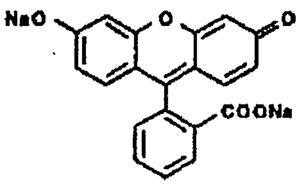 |
| Pyrromethene 650 | 4,4-Difluoro-8-cyano-1,2,3,5,6,7-hexamethyl-4-bora-3 a,4a-diaza-s-indacene 8-Cyano-1,2,3,5,6,7-hexamethylpyrromethenedifluoroborate Complex | 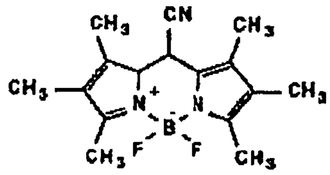 |

(continued)

| Material | Constitution | Molecule |
|---|---|---|
| Oxazine 170 | 9-Ethylamino-5-ethyliniino-10-methyl-5H-beazo(a)phenoxazonium Perchlorate | 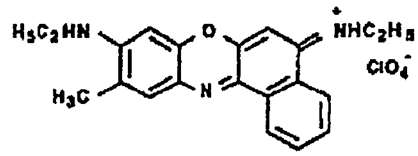 |
| Oxazine.1 | 3-Diethylamino-7-diethyliminophenoxazonium Perchlorate | 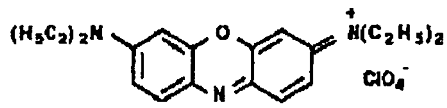 |
| Pyrromethene 546 | 4,4-Difluoro-1,3,5,7,8-pentamethyl-4-bora-3a,4a-diaza-s-indacene 1,3,5,7,8-Pentamethylpyrromethenedifluoroborat e Complex | 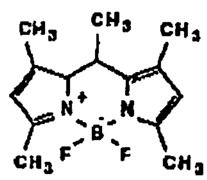 |
| Rhodamine 110 | o-(6-Amino-3-imino-3H-xanthen-9-yl)-benzoic acid | 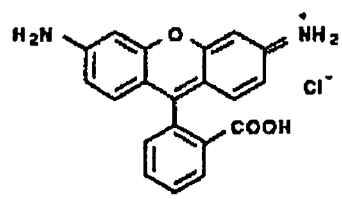 |
| Rhodamine 6G | Benzoic Acid, 2-[6(ethylamino)-3-(ethylimino)-2,7-dimethyl-3H-xanthen-9-yl]-ethyl esther, monohydrochloride | 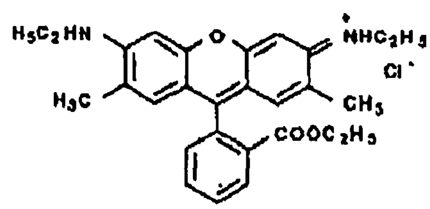 |
| Rhodamine B | 2-[6-(Diethylamino)-3-(diethylimino)-3H-xanthen-9-yl] benzoic acid | 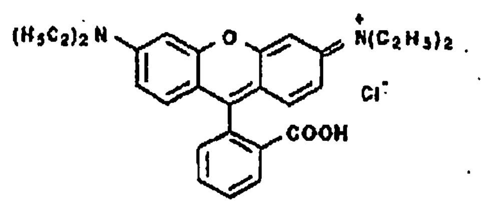 |
| Pyrromethene 567 | 4,4 - Difluoro-2,6-diethyl-1,3,5,7,8-pentamethyl-4-bora-3a,4a-diaza-s-indacene 2,6-Diethyl-1,3,5,7,8-pentamethylpyrromethenedifluoroborat e Complex | 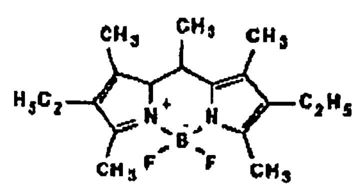 |
| Pyrromethene 580 | 4;4-Difluoro-2,6-di-n-butyl-1,3,5,7,8-pentamethyl-4-bora-3a,4a-diaza-s-indacene 2,6-Di-n-butyl-1,3,5,7,8-pentamethylpyrromethenedifluoroborat e Complex | 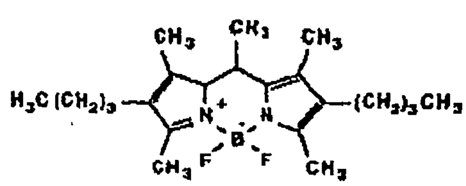 |

(continued)

| Material | Constitution | Molecule |
|---|---|---|
| Cresyl Violet | 5,9 - Diaminobenzo[a]phenoxazonium Perchlorate | 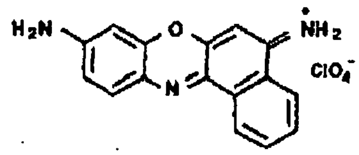 |
| Pyromethene 597 | 4,4-Difluoro-2,6-di-t-butyl-1,3,5,7,8-pentamethyl-4-bora-3a,4a-diaza-s-indacene 2,6-Di-t-butyl-1,3,5,7,8-pentamethylpyrromethenedifluoroborat e Complex | 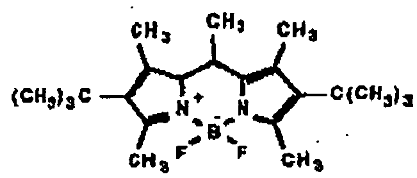 |
| Pyrromethene 556 | Disodium-1,3,5,7,8-pentamethylpyrromethene-2,6-disulfonate-difluoroborate complex | 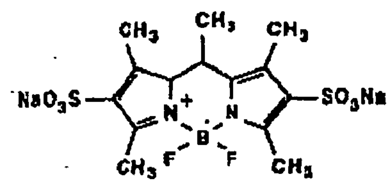 |
| IR132 | Naphtho[2,3-d]thiazolium, 2-[2-[2-(diphenylamino)-3-[[3-(4-methoxy-4-oxobutyl) naphtho [2,3-d] thiazol-2 (3H)-ylidene] ethylidene]-1-cyclopenten-1-yl] ethenyl]-3-(4-methoxy-4-oxobutyl)-, perchlorate (9Cl) | 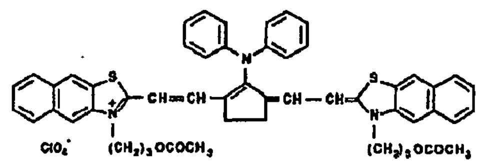 |
| DDCI-4 | 1,2'- Diethyl - 4,4' - dicarbocyanine Iodide | 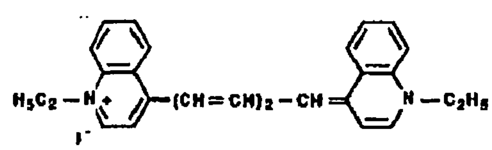 |

Table 2

| **Material** | **Abs (nm)** | **Em (nm)** | **Difference (nm)** | **Difference (eV)** |
|---|---|---|---|---|
| Fluorescein 27 | 512 | 530 | 18 | 0.0777 |
| Sulforhodamine B | 556 | 575 | 19 | 0.0696 |
| Uranin | 500 | 521 | 21 | 0.0944 |
| Pyrromethene 650 | 590 | 612 | 22 | 0.0714 |
| Oxazine 170 | 627 | 650 | 23 | 0.0661 |
| Oxazine 1 | 646 | 670 | 24 | 0.0650 |
| Pyrromethene 546 | 494 | 519 | 25 | 0.1142 |
| Rhodamine 110 | 510 | 535 | 25 | 0.1073 |
| Rhodamine 6G | 530 | 556 | 26 | 0.1034 |
| Rhodamine B | 552. | 580 | 28 | 0.1025 |

(continued)

| Material | Abs (nm) | Em (nm) | Difference (nm) | Difference (eV) |
|---|---|---|---|---|
| Pyrromethene 567 | 518 | 547 | 29 | 0.1199 |
| Pyrromethene 580 | 519 | 550 | 31 | 0.1272 |
| Cresyl Violet | 601 | 632 | 31 | 0.0956 |
| Pyrromethene 597 | 524 | 557 | 33 | 0.1325 |
| Pyrromethene 556 | 498 | 533 | 35 | 0.1545 |
| IR132 | 830 | 861 | 31 | 0.0508 |
| DDCI-4 | 815 | 850 | 35 | 0.0592 |

Further description of the materials listed in Tables 1 and 2, along with additional materials may be found in "Lambdachrome® Laser Dyes" (Third Edition, January 2000) by Ulrich Brackmann, published by Lambda Physik AG, Hans-Boeckler-Strasse 12, D-37079 Goettingen, Germany. A copy may be available on the web at <http://dutch.phys.strath.ac.uklFRC/stuff/lBlue_book/Lamdachrome-laser-dyes.pdf>. This listing is not meant to be comprehensive, and other suitable acceptor and donor materials may be used.

As described above, devices having the low FCS donor-acceptor heterojunctions described above may be photovoltaic devices or photodetectors, since the low FCS photoactive regions each include a rectifying heterojunction.

Examples of the invention are illustrated and/or described herein. However, it will be appreciated that modifications and variations of the invention are covered by the above teachings and within the purview of the appended claims without departing from the spirit and scope of the invention.

**Claims**

1. A photosensitive device comprising: an anode and a cathode; and a first organic material and a second organic material forming a donor-acceptor heterojunction electrically connected between the anode and the cathode, wherein the first and second organic materials, as arranged in the photosensitive device and/or if measured in solution form, each have a Franck-Condon Shift of less than 0.5 eV.

2. The photosensitive device of claim 1, wherein both the first and second organic materials as arranged in the photosensitive device have Franck-Condon Shifts of less than 0.2 eV.

3. The photosensitive device of claim 2, wherein the Franck-Condon Shift of at least one of the first and second organic materials as arranged in the photosensitive device is less than 0.1 eV.

4. The photosensitive device of claim 3, wherein both the first and second organic materials as arranged in the photosensitive device have Franck-Condon Shifts of less than 0.1 eV.

5. The photosensitive device of claim 1, 2, 3 or 4, wherein both the first organic material and the second organic material, if measured in solution form, have Franck-Condon Shifts of less than 0.2 eV.

6. The photosensitive device of claim 5, wherein both the first organic material and the second organic material, if measured in solution form, have Franck-Condon Shifts of less than 0.1 eV.

7. The photosensitive device of one of the preceding claims, wherein at least one of the first and second organic materials is arranged to form a J-aggregate in the photosensitive device.

8. The photosensitive device of one of the preceding claims, wherein at least one of the first and second organic materials is arranged in the photosensitive device as a stack of at least three molecules oriented so that planes of the molecules are parallel, the stack being absent of disruptions, stacking faults, and dislocations.

9. The photosensitive device of one of the preceding claims, wherein at least one of the first and second organic materials consists of molecules with no single-bonded pendant side groups.

**10.** The photosensitive device of one of the preceding claims, wherein at least one of the first and second organic materials consists of planar molecules having fused rings.

**11.** The photosensitive device of claim 10, wherein the planar molecules having fused rings are selected from the group consisting of benzene, porphyrins, phthalocyanines, and polyacenes,

**12.** The photosensitive device one of the preceding claims, wherein the donor-acceptor heterojunction forms a first photovoltaic cell, the device further comprising:

a stack of photovoltaic cells, each cell comprising a donor-acceptor heterojunction, the first photovoltaic cell being within the stack; and
an electrically conductive material between two of the photovoltaic cells in the stack, the electrically conductive material being arranged as:

a charge transfer layer having no electrical connections external to the stack,
a recombination zone having no electrical connections external to the stack, or
an electrode having an electrical connection external to the stack.

**13.** The photosensitive device of one of the preceding claims, wherein the donor-acceptor heterojunction is selected from the group consisting of a bulk heterojunction, a mixed heterojunction, a planar heterojunction, and a hybrid heterojunction.

**14.** The photosensitive device of one of the preceding claims, wherein at least one of the first and second organic materials comprises molecules having fused rings.

**15.** A method, in particular method for manufacturing a device of one of the preceding claims, the method comprising:

providing a first electrically conductive layer;
arranging a first organic material and a second organic material over the first electrically conductive layer to form a donor-acceptor heterojunction; and
forming a second electrically conductive layer over the first and second organic materials,
wherein each of the first and second organic materials have a Franck-Condon Shift of less than 0.5 eV, if measured in solution form and/or, as arranged to form the donor-acceptor heterojunction, if measured after the second electrically conductive layer is formed.

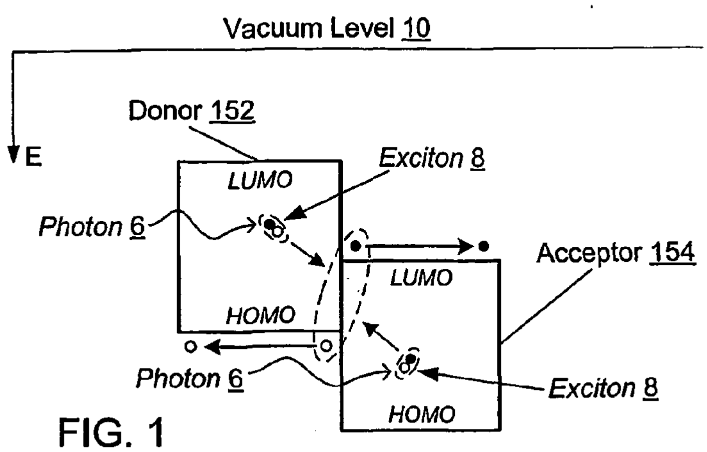


FIG. 1

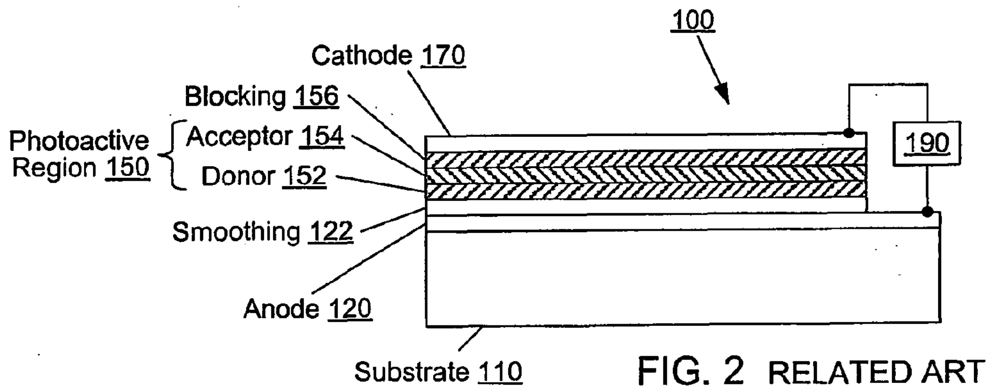


FIG. 2 RELATED ART

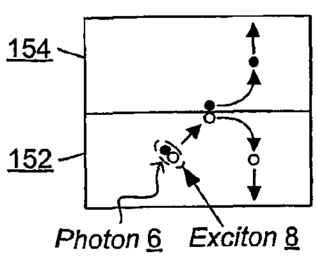


FIG. 3

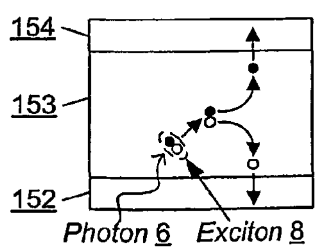


FIG. 4

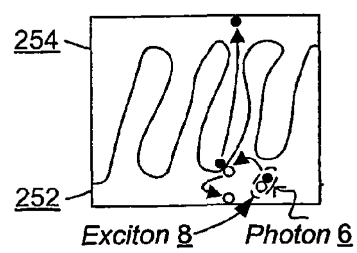


FIG. 5

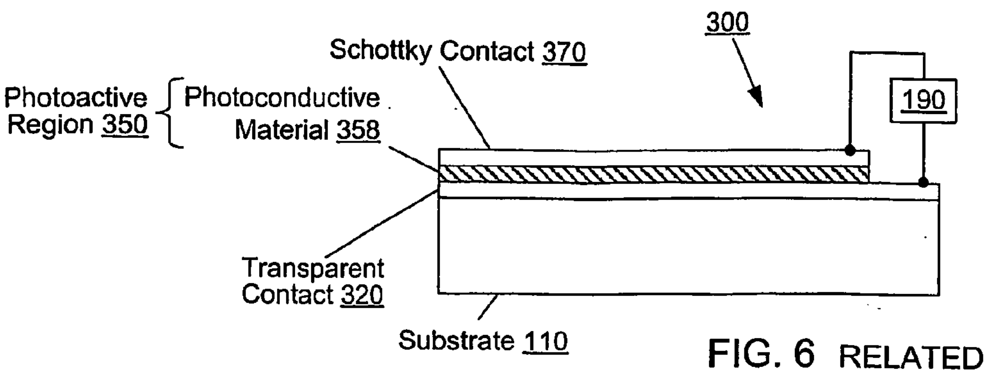


FIG. 6 RELATED ART

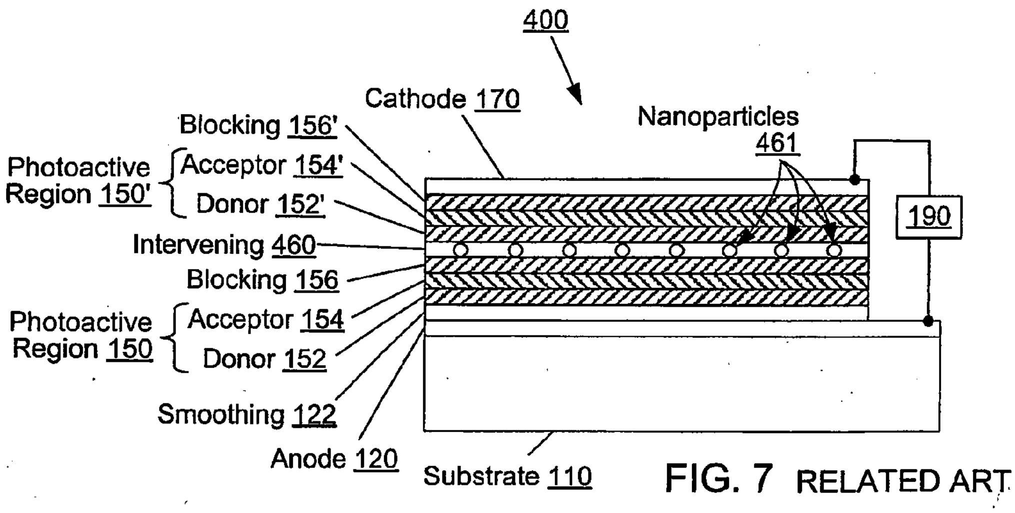


FIG. 7 RELATED ART

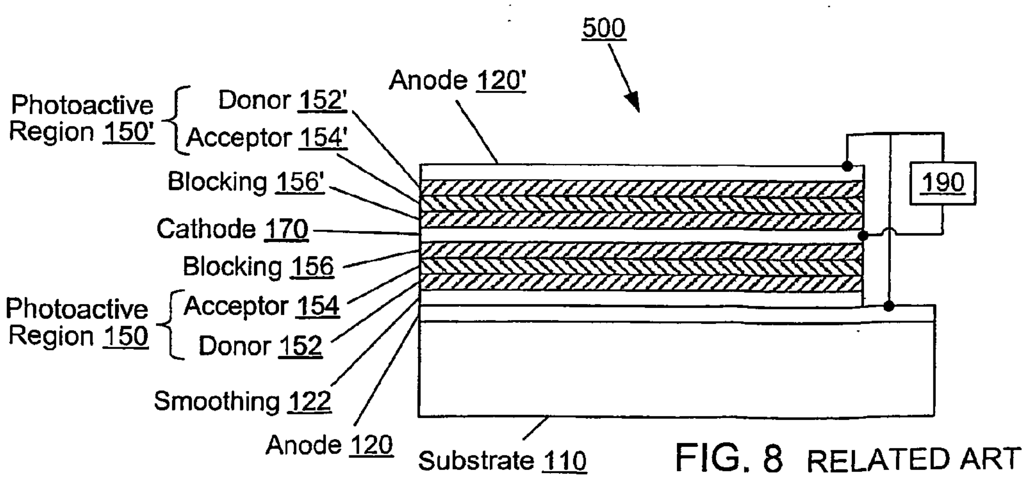


FIG. 8 RELATED ART

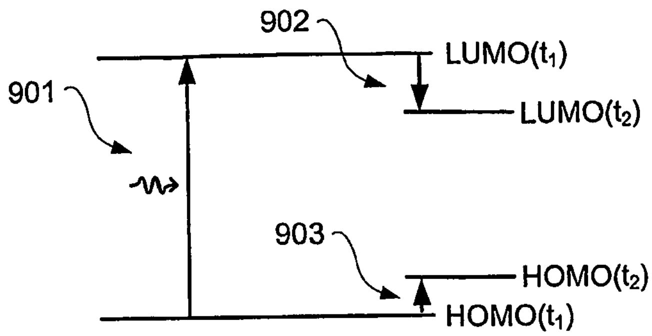


Figure 9

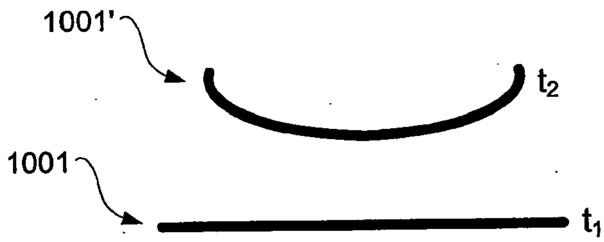


Figure 10

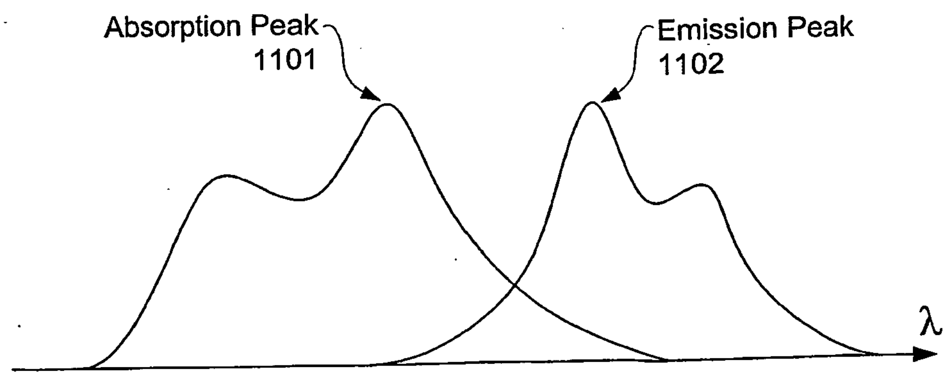


Figure 11

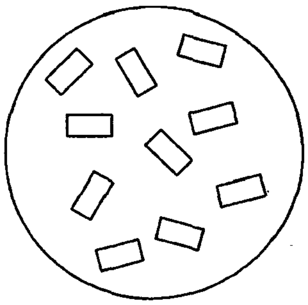

Figure 12A

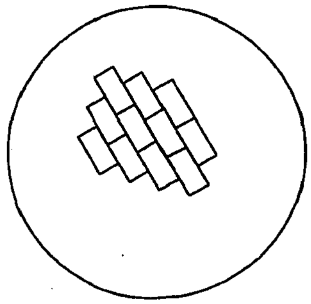

Figure 12B

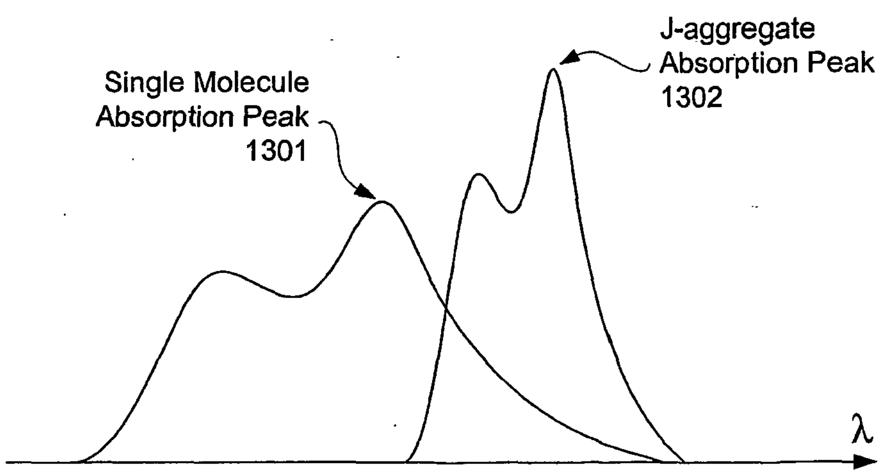


Figure 13

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- US 6657378 B, Forrest
- US 6580027 B, Forrest
- US 6352777 B, Bulovic
- US 6451415 B, Forrest
- US 6420031 B, Parthasarathy
- US 91037104 A
- US 20050110007 A1, Forrest
- US 91541004 A
- US 97914504 A
- US 6333458 B, Forrest
- US 6440769 B, Peumans
- US 10857747 B


### Non-patent literature cited in the description


- **PEUMANS et al.** Efficient photon harvesting at high optical intensities in ultrathin organic double-heterostructure photovoltaic diodes. *Applied Physics Letters,* 2000, vol. 76, 2650-52
- Inorganic Chemistry. Prentice Hall, 1999
- Electronic Process in Organic Crystals and Polymers. Oxford University Press, 1999
- **BULOVIC et al.** *Chemical Physics,* 1996, vol. 210, 1-12
- Self Assembly of Cyanine Dye on Clay Nanoparticles. **DIXON et al.** American Journal of Undergraduate Research. 2005, vol. 3, 29-34
- **FORREST.** Ultrathin Organic Films Grown By Organic Molecular Beam Deposition and Related Techniques. *Chemical Review,* 1997, vol. 97, 1793-1896
- **ULRICH BRACKMANN.** Lambdachrome® Laser Dyes. Lambda Physik AG, Hans-Boeckler-Strasse, January 2000, vol. 12, D-37079